# EUROPÄISCHE PATENTSCHRIFT

(11) **EP 1 628 015 B1**
(45) Veröffentlichungstag und Bekanntmachung des Hinweises auf die Patenterteilung: **15.08.2007**
(21) Anmeldenummer: 04104652.5
(22) Anmeldetag: 24.09.2004
(51) Int. Cl.: F02M 51/00, F02M 61/16, H01L 41/053

(54) **Abdichtungsanordnung eines Piezoaktors eines Kraftstoffinjektors**
Sealing arrangement of a piezo actuator of a fuel injector
Système d'étanchéité pour actionneur piezoélectrique d'injecteur de carburant

(30) Priorität: 20.08.2004 DE 102004040491
(43) Veröffentlichungstag der Anmeldung: 22.02.2006
(73) Patentinhaber: SIEMENS AKTIENGESELLSCHAFT, 80333 München (DE)
(72) Erfinder: Schmutzler, Gerd, 93138 Kareth (DE); Unruh, Marcus, 93197 Zeitlarn (DE)

(56) Entgegenhaltungen:
- DE-A1- 4 410 367
- DE-A1- 10 251 225
- US-A- 5 685 493
- US-A- 6 047 686

## Beschreibung

Die vorliegende Erfindung betrifft eine Abdichtungsanordnung nach dem Oberbegriff des Anspruchs 1.

Eine derartige Anordnung ist beispielsweise aus der DE 102 51 225 A1 bekannt. Bei diesem Stand der Technik wird zur Schaffung einer dauerhaften, insbesondere öldichten Abdichtung zwischen einem Piezoaktor und einer Außenkontaktierung vorgeschlagen, einen kraftstoffbeständigen Dichtring (O-Ring) in jede Öffnung einer aufgesetzten Kopfplatte einzusetzen. In jeder Durchtrittsöffnung ist außerdem unterhalb des Dichtrings eine Hülse aus Isolationsmaterial eingesetzt, die eine Zentrierung und elektrische Isolation des Anschlussstifts bewirkt.

US 5 685 943 A offenbart einen Injektor mit einer gaspermeablen Membran im Bereich einer Magnetspule.

Nachteilig ist bei dieser bekannten Piezoaktorkontaktierung, dass diese eine vergleichsweise dicke Kopfplatte erfordert, um in deren Durchtrittsöffnungen jeweils einen Dichtring und eine Zentrierhülse unterzubringen.

Es ist daher eine Aufgabe der vorliegenden Erfindung, eine Abdichtungsanordnung der eingangs erwähnten Art so weiterzubilden, dass eine zuverlässige Abdichtung insbesondere auch für vergleichsweise dünne Kopfplatten ermöglicht wird.

Diese Aufgabe wird gelöst mit einer Abdichtungsanordnung nach Anspruch 1. Die abhängigen Ansprüche betreffen vorteilhafte Weiterbildungen der Erfindung.

Die erfindungsgemäße Abdichtungsanordnung ist gekennzeichnet durch eine auf die Kopfanordnung aufgesetzte und mit Öffnungen zum Durchtritt der Anschlussstifte versehene Abdichteinheit, die einen Träger aufweist, an welchem ein dichtendes Material angeordnet ist, das an Umfangsflächen der Anschlussstifte und an einem Umfangsbereich der Kopfanordnung dichtend anliegt, und an welchem ein aus mikroporösem Material gebildetes Teil zur Schaffung einer Gaspermeabilität integriert ist.

Durch die dichtende Anlage sowohl an den Umfangsflächen der Anschlussstifte als auch an der Kopfanordnung wird eine zuverlässige Abdichtung ermöglicht. Diese Abdichtung liegt außerhalb des von den Durchtrittsöffnungen begrenzten Bauraums, so dass unabhängig von diesem begrenzten Bauraum der Durchtrittsöffnungen eine erhöhte konstruktive Gestaltungsfreiheit gegeben ist und diese Abdichtung insbesondere auch für vergleichsweise dünne Kopfplatten geeignet ist.

Hinsichtlich der Montage eines Kraftstoffinjektors ermöglicht die Erfindung vorteilhaft die Realisierung der Abdichtung eines mit mehreren Anschlussstiften versehenen Piezoaktors durch Montage einer einzigen Komponente (Abdichteinheit).

Die erhöhte konstruktive Gestaltungsfreiheit, die sich aus der Abdichtung außerhalb des begrenzten Bauraums der Durchtrittsöffnungen ergibt, wird gemäß der Erfindung weiter zur Schaffung einer Gaspermeabilität durch ein an dem Träger integriertes Teil aus mikroporösem Material genutzt.

Eine bevorzugte Verwendung der erfindungsgemäßen Abdichtungsanordnung ergibt sich für den Piezoaktor eines Kraftstoffinjektors einer Brennkraftmaschine, bei welcher der Kraftstoffinjektor und wenigstens eine weitere Komponente einer Kraftstoffeinspritzeinrichtung im Wesentlichen vollständig innerhalb einer Motorblockbaugruppe der Brennkraftmaschine angeordnet sind. Damit ist insbesondere der Fall gemeint, in welchem Komponenten der Einspritzeinrichtung innerhalb der Motorblockbaugruppe untergebracht sind, die ohne Einschränkung ihrer Funktion auch außerhalb derselben angeordnet werden könnten. Der Begriff "Motorblockbaugruppe" bezeichnet hierbei die Gesamtheit der Motorschmieröl enthaltenden Komponenten, also den "Motorblock" im engeren Sinne und Anbauteile (wie z. B. einen Zylinderkopfdeckel etc.), in denen das Schmieröl gepumpt wird oder schmiert oder (zurück)geführt wird. Bei einer solchen Motorkonstruktion besteht eine erhöhte Gefahr eines Eintrags von schädlichen Medien wie Öl und/oder Kraftstoff in den Innenraum eines Injektorgehäuses. Diese Problematik ergibt sich insbesondere für Common-Rail-Dieselmotoren mit innerhalb des Zylinderkopfdeckels liegenden Einspritzkomponenten.

Bei internen betrieblichen Versuchen der Anmelderin hat sich überraschenderweise herausgestellt, dass die Anordnung eines piezokeramischen Bauteils wie des hier interessierenden Piezoaktors in einer "möglichst gasdichten" Piezogehäuseanordnung in einer schädliche Medien aufweisenden Installationsumgebung die Lebensdauer des Bauteils in der Praxis nicht verlängert sondern tendenziell sogar eher verkürzt.

Demgegenüber kann durch eine gewisse "Gasdurchlässigkeit" im Bereich der Abdichtungsanordnung eine erhebliche Verlängerung der Haltbarkeit bzw. Lebensdauer des Piezoaktors erzielt werden. Eine mögliche Erklärung besteht darin, dass bei einem möglichst gasdicht abgedichteten Piezogehäuse unter bestimmten Betriebsbedingungen ein Unterdruck im Gehäuseinnenraum entsteht (z. B. durch Temperaturschwankungen), durch welchen schädliche Medien durch die in der Praxis nicht absolut hermetisch auszubildende Abdichtung hindurch in den Gehäuseinnenraum gelangen können. Andere mögliche Erklärungen bestehen beispielsweise darin, dass sich nach der Fertigung eines hermetisch abgeschlossenen Piezoantriebs die Konzentration irgendeines die Lebensdauer verkürzenden Gases im Innenraum des Piezoantriebs erhöht bzw. das eine der atmosphärischen Luft ähnelnde Füllung des Gehäuseinnenraums eine positive Wirkung auf die Lebensdauer der piezoelektrischen Keramik besitzt.

Durch die gemäß der Erfindung vorgesehene Integration des mikroporösen Materials wird eine gewisse Gasdurchlässigkeit bzw. Druckausgleichsfähigkeit der Abdichtungsanordnung und somit der vorteilhafte Effekt einer Verlängerung der Haltbarkeit bzw. Lebensdauer des Piezoaktors erzielt.

Die Integration des permeablen Teils an dem Träger ist bevorzugt derart vorgesehen, dass sich wenigstens ein Gasaustauschpfad durch die Abdichteinheit hindurch ergibt, in dessen Verlauf zwar das mikroporöse Material liegt, jedoch kein Trägermaterial und kein Dichtmaterial. Damit wird das Gasaustauschvermögen der Abdichtungsanordnung im Wesentlichen unabhängig von dem Trägermaterial und dem Dichtmaterial erzielt. Letztere Materialien können dann für ihre jeweiligen Aufgaben besonders geeignet ausgewählt werden.

Als Material für den Träger kann beispielsweise Kunststoff verwendet werden.

Für das dichtende Material ist die Verwendung eines Elastomers bevorzugt, beispielsweise um eine dauerhaft vorgespannte Dichtanlage an den Anschlussstiften und der Kopfanordnung zu erzielen.

In fertigungstechnisch einfacher Weise lässt sich das dichtende Material z. B. als eine Umspritzung des Trägers ausbilden. Alternativ kann das am Träger angeordnete dichtende Material ganz oder teilweise als eine Komponente in einem ZweiKomponenten-Spritzgussverfahren bereitgestellt werden.

In einer Ausführungsform ist vorgesehen, dass zwischen dem Träger und dem dichtenden Material eine innige Verbindung durch eine Vulkanisation geschaffen ist.

Insbesondere wenn die Verbindung zwischen dem dichtenden Material und dem Träger an der Abdichteinheit als solcher noch keine besonders gute Abdichtung bereitstellt, also wenn diese Materialien an der Abdichteinheit z. B. lediglich aneinander anliegen, so ist es bevorzugt, wenn - zumindest im installierten Zustand - das dichtende Material zum Träger hin verpresst ist. Eine derartige Verpressung im montierten Zustand eines Kraftstoffinjektors kann beispielsweise durch Ausübung von Druck durch eine so genannte Kontaktbaugruppe realisiert werden, die zur elektrischen Weiterverbindung der Anschlussstifte zu einer Außenkontaktierung (Steckverbinder) des Kraftstoffinjektors führt.

Eine Verpressung derjenigen Abschnitte des dichtenden Materials, welche zur Anlage an die Anschlussstifte kommen (Radialabdichtung), sowie derjenigen Abschnitte des Dichtmaterial, die an der Kopfanordnung zur Anlage kommen (Axialabdichtung), besitzt den weiteren Vorteil, dass damit die Abdichtwirkung verbessert werden kann.

Auch die Verbindung zwischen dem mikroporösen Material und dem Trägermaterial sollte möglichst innig vorgesehen sein. In einer bevorzugten Ausführungsform ist das aus dem mikroporösen Material gebildete Teil daher mit dem Träger verschweißt. Eine solche Verschweißung eignet sich z. B. zur Integration eines aus ePTFE (expandiertes Polytetrafluorethylen) gebildeten Gasaustauschteils. Dieses Material hat sich auch insofern als sehr vorteilhaft herausgestellt, als damit "schädliche Medien" wie Kraftstoff (Diesel, Benzin, etc.) oder Schmierstoffe (z. B. Motoröl) am Eindringen in den Aktorraum gehindert werden können, wohingegen flüchtige Stoffe aus dem Aktorraum heraus und Luft bzw. Sauerstoff in den Aktorraum hinein diffundieren können. Andere hier verwendbare mikroporöse Materialien sind dem Fachmann wohlbekannt und bedürfen daher keiner weiteren Erläuterung.

Für einen kompakten Aufbau der Abdichtungsanordnung ist es von Vorteil, wenn das Gasaustauschteil im Wesentlichen scheibenförmig ist, beispielsweise ausgebildet als Membran. Eine derartige Gasaustauschscheibe kann sich z. B. über den gesamten Querschnitt einer Durchgangsöffnung der Abdichteinheit erstrecken und am Umfang mit dem angrenzenden Material (z. B. Trägermaterial) verschweißt sein (z. B. mittels Ultraschallverschweißung, Laserverschweißung, etc.). Alternativ kann die Scheibe auch durch eine ringsherum abdichtende Presspassung in eine solche Durchgangsöffnung eingefügt sein.

Die Erfindung wird nachfolgend anhand von Ausführungsbeispielen mit Bezug auf die beigefügten Zeichnungen näher beschrieben. Es stellen dar:
- Fig. 1: eine Schnittansicht einer Abdichteinheit,
- Fig. 2: eine Schnittansicht einer Abdichteinheit gemäß einer weiteren Ausführungsform,
- Fig. 3: eine Schnittansicht einer Abdichteinheit gemäß einer weiteren Ausführungsform,
- Fig. 4: eine Schnittansicht einer Abdichteinheit gemäß einer weiteren Ausführungsform,
- Fig. 5: eine Schnittansicht einer Abdichteinheit gemäß einer weiteren Ausführungsform,
- Fig. 6: zeigt ein Detail aus Fig. 5 in einer modifizierten Ausführungsform,
- Fig. 7: ist eine der Fig. 6 entsprechende Ansicht gemäß einer weiteren Ausführungsform,
- Fig. 8: ist eine Schnittansicht eines Stellantriebs für einen Kraftstoffinjektor,
- Fig. 9: eine Schnittansicht einer Abdichteinheit gemäß einer weiteren Ausführungsform, und
- Fig. 10: eine perspektivische Ansicht einer Isolierscheibe.

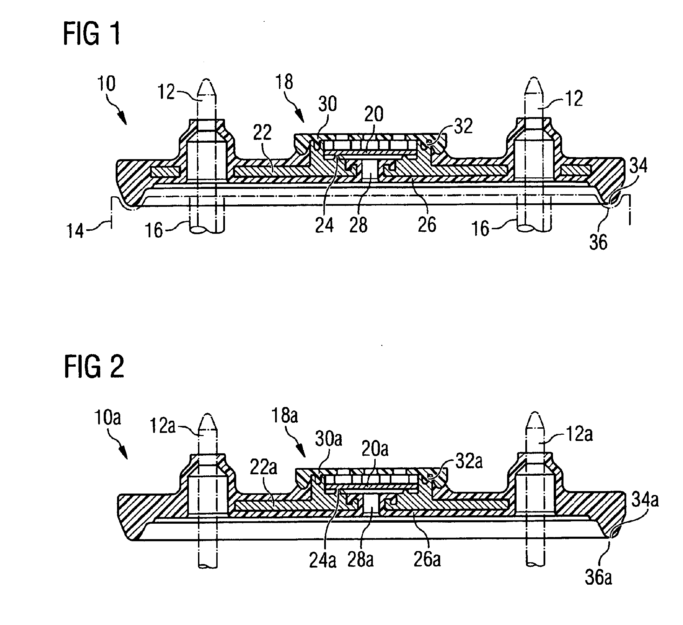

Fig. 1 zeigt eine Abdichtungsanordnung 10 zur Abdichtung eines (nicht dargestellten) Piezoaktors, der als Antriebskomponente eines Stellantriebs für einen Kraftstoffinjektor einer Brennkraftmaschine dient. In der Figur gestrichelt eingezeichnet sind aus dem Piezoaktor hervorstehende Anschlussstifte 12 und eine auf den Piezoaktor aufgesetzte Kopfanordnung 14, die mit Bohrungen 16 zum Durchtritt der Anschlussstifte 12 versehen ist.

Insbesondere für einen vollständig in einem Zylinderkopf einer Brennkraftmaschine integrierten Dieselinjektor eines Common-Rail-Systems muss eine Abdichtung des Piezoaktors vorgesehen werden, die den Aktorraum über die Anschlussstiftkontaktierung (zu einer elektrischen Außenverbindung hin) gegen ein Eindringen von Flüssigkeiten zuverlässig abdichtet. Ansonsten besteht die Gefahr, dass über eine die elektrische Weiterverbindung von den Anschlussstiften 12 zu der Außenkontaktierung vorsehende Kontaktbaugruppe "schädliche Medien" wie Motoröl, kraftstoffverdünntes Motoröl und Wasser in den Aktorraum eindringen können. Es hat sich jedoch herausgestellt, dass eine möglichst große Gaspermeation von "flüchtigen Stoffen" aus dem Aktorraum heraus und Luft bzw. Sauerstoff in den Aktorraum hinein die Haltbarkeit bzw. Lebensdauer des im Aktorraum befindlichen Piezoaktors tendenziell verlängern kann.

Die geforderte gute Flüssigkeitsabdichtung bei gleichzeitiger Schaffung einer Gaspermeabilität ist bei der dargestellten Abdichtungsanordnung 10 durch Montage (Zwischenfügung) einer Abdichteinheit 18 zwischen der Kopfanordnung 14 und der (nicht dargestellten) Kontaktbaugruppe realisiert.

Die mehrteilige, als Montagekomponente vorgefertigte Abdichteinheit 18 umfasst drei im installierten Zustand der Abdichteinheit 18 innig miteinander verbundene Werkstoffe bzw. Abdichteinheitskomponenten, nämlich eine mikroporöse Membran 20 aus ePTFE, einen Träger 22 aus Kunststoff, an welchem die mikroporöse Membran 20 umlaufend (bei 24) verschweißt ist, sowie eine (im dargestellten Beispiel einteilige) Dichtung 26 aus einem Elastomer. Mit diesem Elastomer, mit welchem die Abdichteinheit 18 einerseits an Umfangsflächen der Anschlussstifte 12 und andererseits an einem stirnseitigen Umfangsbereich der Kopfanordnung 14 flüssigkeitsdichtend anliegt, wird eine zuverlässige Abdichtung gegenüber einem Eindringen von schädlichen Medien aus der Umgebung des Kraftstoffinjektors in den Aktorraum unterhalb der Kopfplatte 14 vermieden.

Bei der Fertigung des Verbunds aus dem Träger 22 und dem Dichtmaterial 26 wird der Träger 22 als Einlegeteil in einem Umspritzungsprozess verwendet. Dieses Einlegeteil erstreckt sich im Wesentlichen über die gesamte Radialausdehnung der fertigen Dichtung 26.

Wenngleich es zur Steigerung der Gaspermeabilität der Abdichtungsanordnung 10 durchaus möglich ist, ein Elastomermaterial mit hoher Gaspermeabilität (z. B. Silikon- oder Fluorsilikonmaterial) zu wählen, so ist dies z. B. zugunsten einer hinsichtlich der mechanischen und thermischen Eigenschaften optimierten Elastomerauswahl im Allgemeinen nicht erforderlich, da die Gaspermeabilität durch eine eigens vorgesehene Gasaustauschpassage durch die Abdichteinheit 18 hindurch realisiert wird. Im dargestellten Beispiel ist das als Umspritzung des scheibenförmigen Trägers 22 ausgebildete Dichtmaterial 26 wie auch der Träger selbst im Zentrum mit einer Gasaustauschöffnung 28 versehen, in deren (axialen) Verlauf nach außen die ringsherum mit dem Träger 22 verschweißte gasdurchlässige Membran 20 angeordnet ist.

Mit der Abdichteinheit 18 ist somit eine während der Montage eines Kraftstoffinjektors einfach handzuhabende Baueinheit geschaffen, mittels welcher eine große Permeation bzw. Diffusion von gasförmigen Medien gestattet wird und gleichzeitig ein Eindringen von flüssigen Medien unterbunden wird.

Der Träger 22 besitzt die Hauptaufgabe, die Abdichteinheit 18 mechanisch zu stabilisieren. Dies insbesondere im Hinblick auf die mikroporöse Membran 20, die als Filterelement sehr empfindlich gegenüber mechanischer Beschädigung ist. Da der Träger 22 nicht wesentlich für die zu bezweckende Abdichtungswirkung ist, kann dessen Material vergleichsweise frei gewählt werden. Im dargestellten Beispiel ist eine wesentliche Materialanforderung lediglich die Verschweißbarkeit mit dem Werkstoff der Membran 20 sowie eine gute Abdichtwirkung an den Grenzflächen zwischen dem Trägermaterial und dem Dichtmaterial 26.

Zur weiteren Stabilisierung und zum Schutz der Membran 20 ist im dargestellten Beispiel noch ein Schutzdeckel 30 vorgesehen, der durch eine Ultraschallverschweißung (bei 32) fest mit dem Träger 22 verbunden ist. Der hier als "Schutzgitter" ausgebildete Schutzdeckel 30 stabilisiert ferner den Träger 22 und besitzt bei dem dargestellten Ausführungsbeispiel noch die Funktion, im aufgesetzten und verschweißten Zustand axialen Druck auf Materialabschnitte der Dichtung 26 auszuüben, so dass eine innige uns somit gut abdichtende Verbindung zwischen Dichtung 26 und Träger 22 dauerhaft aufrechterhalten wird. Schließlich schützt der Schutzdeckel 30 die Membran 20 auch gut für den Fall, dass die Abdichteinheit 18 im Rahmen eine automatisierten Fertigung des Kraftstoffinjektors eingebracht wird.

Sofern eine schützende Wirkung gegen Membranbeschädigung (z. B. mittels Schutzgitter) im konkreten Anwendungsfall nicht erforderlich ist, so könnte der Schutzdeckel alternativ z. B. auch als Pressring ausgeführt werden, der dann ebenfalls stabilisiert und das Dichtungsmaterial 26 verpresst.
Wenn die Membran 20 - wie dargestellt - in einem hülsenartigen, seitlich zinnenartig offenen Aufnahmeabschnitt des Trägers 22 angeordnet ist, so könnte der Schutzdeckel 30 auch massiv (z. B. ohne "Gitteröffnungen") ausgeführt sein, da die Belüftung der Membranaußenseite bereits seitlich, durch Zwischenräume zwischen den Trägermaterialzinnen hindurch, gewährleistet ist.

Das Material der Dichtung 26 liegt mit elastischer Vorspannung an den Umfangsflächen der Anschlussstifte 12 an . Dies ist dadurch realisiert, dass die Dichtung 26 aus elastischem Material mit Öffnungen zum Durchtritt der Anschlussstifte 12 gebildet ist und jede Öffnungsquerschnittsfläche im entspannten Zustand der Dichtung 26 kleiner als die Querschnittsfläche des betreffenden Anschlussstiftabschnitts im Bereich der Radialabdichtung ist.

Die zuverlässige Axialabdichtung erfolgt im dargestellten Ausführungsbeispiel dadurch, dass ein ringförmiger, nach unten abstehender Vorsprung ("Dichtlippe") 34 in eine korrespondierende Ringnut 36 der Kopfanordnung 14 gepresst wird. Diese Verpressung im Bereich der Axialabdichtung wird durch Ausübung axialen Drucks von der (nicht dargestellten) Kontaktbaugruppe zum elektrischen Anschluss des Kraftstoffinjektors vorgesehen. Die Kontaktbaugruppe presst die Dichtung 26 wenigstens abschnittsweise gegen die Kopfanordnung 14, so dass die belasteten Dichtungsabschnitte zwischen der Kontaktbaugruppe und der Kopfanordnung 14 eingeklemmt werden.

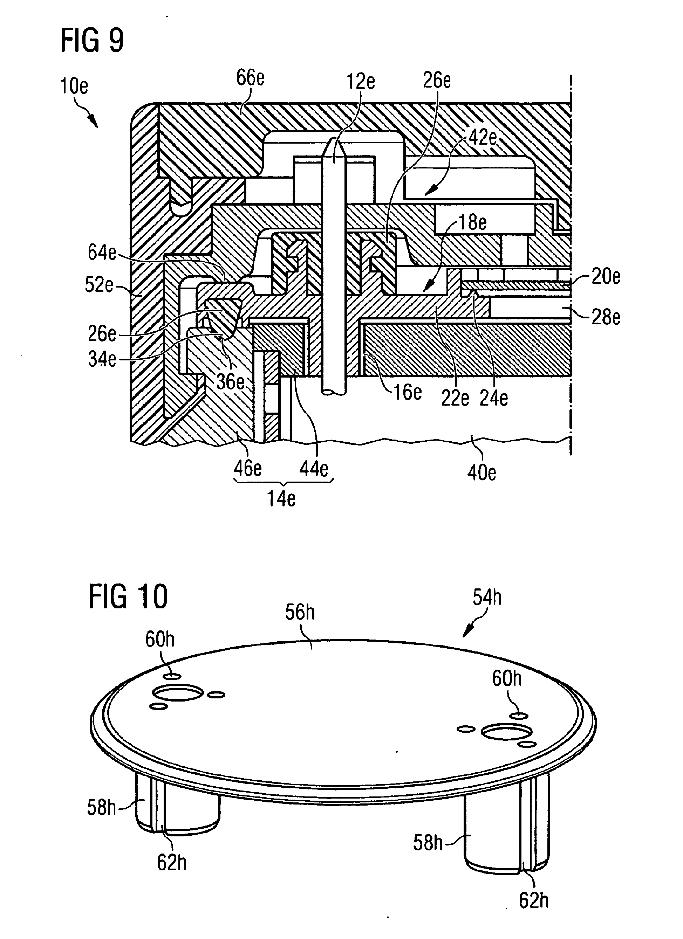

Das für die Dichtung 26 verwendete Elastomermaterial ist elektrisch isolierend. Durch diese Materialwahl sind keine besonderen Vorkehrungen gegen eine unzureichende elektrische Isolierung der Anschlussstifte 12 in dem Fall zu treffen, in welchem die Kopfanordnung elektrisch leitet. Letzteres ist in der Regel der Fall, da diese üblicherweise aus metallischen Werkstoffen hergestellt wird. Für den Fall, dass bei einer elektrisch leitenden Kopfanordnung 14 das Material der Dichtung 26 nicht ausreichend elektrisch isoliert, kann vorgesehen sein, dass zumindest in den Bereichen der Anlage der Dichtung 26 an der Kopfanordnung 14 die Kopfanordnung elektrisch isoliert ist z. B. mit einer Isolationsschicht bzw. einem Isolationsteil versehen ist. Diese Isolationsschicht kann beispielsweise als eine unten (vgl. z. B. Fig. 10) noch erläuterte Isolierscheibe ausgebildet sein, die sich bis nahe zum Umfangsbereich der Kopfanordnung 14 erstreckt und ebenfalls Öffnungen zum Durchtritt der Anschlussstifte 12 aufweist. Eine solche Isolierscheibe kann vorteilhaft mit Hülsenfortsätzen versehen sein (z. B. einteilig angeformt), die sich in die Bohrungen 16 der Kopfanordnung 14 hinein erstrecken, um die Anschlussstifte 12 dort gegenüber der Innenwandung dieser Bohrungen 16 zu isolieren.

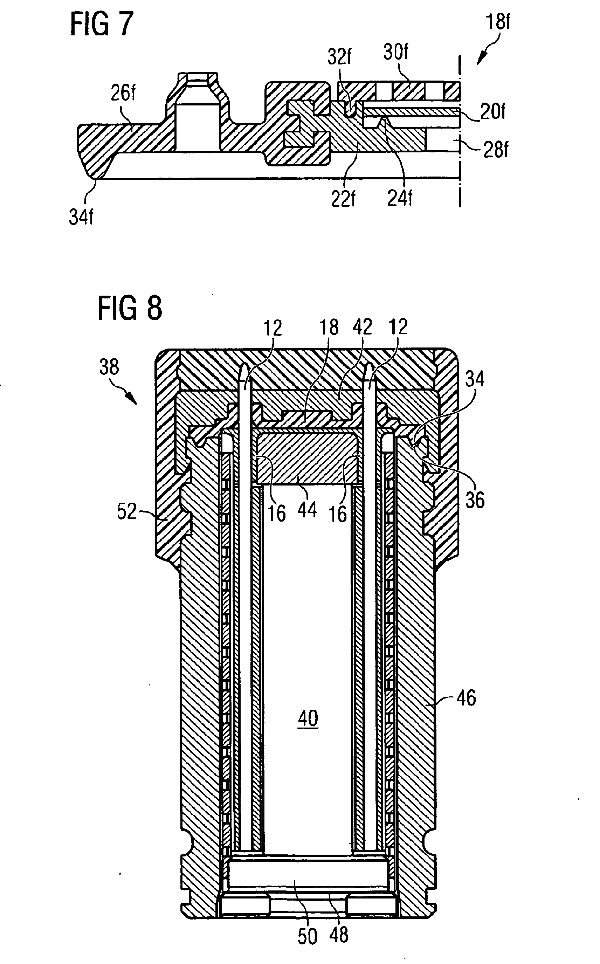

Fig. 8 veranschaulicht die Installationsumgebung der Abdichteinheit 18 in einem Stellantrieb 38 des Kraftstoffinjektors.

In an sich bekannter Weise umfasst der Stellantrieb 38 einen im Wesentlichen aus einem Piezoelementstapel gebildeten, in einer Axialrichtung langgestreckten Piezoaktor 40, dessen axiale Ausdehnung in gesteuerter Weise durch Anlegen einer Steuerspannung über die metallischen Anschlussstifte 12 verändert werden kann.

Die elektrische Weiterverbindung der Anschlussstifte 12 zu Kontaktzungen einer elektrischen Außenverbindung ("Steckverbinder") ist mittels eines an die Enden der Anschlussstifte 12 angeschweißten Kontaktzungenträgers realisiert, der im dargestellten Beispiel die Kontaktbaugruppe 42 ausbildet. Zum prinzipiellen eines solchen Kontaktzungenträgers sei beispielhaft auf die DE 198 44 743 C1 verwiesen.

Ferner erkennt man eine auf den Piezoaktor 40 aufgesetzte Kopfplatte 44, die zusammen mit einem hülsenförmigen Aktorgehäuse 46 und einer am unteren Ende des Gehäuses eingeschweißten Abdichtungsmembran 48 den Aktorraum begrenzt. Innerhalb dieses Aktorraums ist der Piezoaktor 40 unter axialer Druckvorspannung in einer Rohrfeder gehalten, die an ihrem unteren Ende mit einer axial bewegbar im Aktorgehäuse 46 geführten Bodenplatte 50 verschweißt ist. Der Piezoaktor 40, die Kopfplatte 44, die Rohrfeder sowie die Bodenplatte 50 bilden eine Aktoreinheit, die bei der Montage des Stellantriebs 38 in das hülsenförmige Aktorgehäuse 46 eingesetzt wird. Im Bereich der Membran 48 ist in an sich bekannter Weise eine Wirkverbindung zwischen dem Piezoantrieb und einem Kraftstoffeinspritzventil vorgesehen, um die axiale Längenveränderung des Piezoaktors 40 auf ein Betätigungsglied des Einspritzventils zu übertragen.

Aus Fig. 8 ist ersichtlich, dass der ringförmige Dichtlippenvorsprung 34 der Abdichteinheit 18 in die am oberen Ende des Aktorgehäuses 46 ausgebildete Ringnut 36 dichtend eingreift (Axialabdichtung). Dieser Eingriff erleichtert die Montage und verhindert ein Verrutschen der Abdichteinheit 18, wenn diese bei der Montage des Stellantriebs 38 durch die hierfür vorgesehenen Materialabschnitte der Kontaktbaugruppe 42 verpresst wird. Alternativ könnte hierfür auch eine andere Formgestaltung dieser Grenzfläche zwischen dem Axialabdichtungsmaterial (Vorsprung 34) und der Kopfanordnung 44, 46 vorgesehen sein, etwa mit wenigstens einem Absatz bzw. mit wenigstens einem nicht-ebenen Grenzflächenbereich. Alternativ oder zusätzlich kann eine solche besondere Formgestaltung auch an der Grenzfläche zwischen der Abdichteinheit 18 und der Kontaktbaugruppe 42 vorgesehen sein. Wesentlich ist, dass im montierten Zustand die Kontaktbaugruppe 42 mit ihrer Unterseite wenigstens auf den ringförmigen Bereich der Axialabdichtung drückt, um durch diese Verpressung ein besonders dichtes Anliegen des Vorsprungs 34 in der Nut 36 zu gewährleisten. Auf Grund der Elastizität des verwendeten Dichtmaterials 26 wird die abdichtende Wirkung dauerhaft gewährleistet.

Die Kontaktbaugruppe 42 umgreift einen Umfangsbereich des Aktorgehäuses 46 und wird nach dem Aufdrücken durch eine in diesem Bereich vorgesehene Rastverbindung gehalten. Dies kann z. B. mit umlaufender Verrastung oder durch einzelne Rasten über den Umfang verteilt vorgesehen sein.

Bei der Montage des Stellantriebs 38 wird die Abdichteinheit 18 an den aus den Bohrungen 16 hervorstehenden Abschnitten der Anschlussstifte 12 aufgesetzt. Sodann wird durch Aufdrücken und Einrasten der Kontaktbaugruppe 42 die Verpressung bewerkstelligt. Dann erfolgt eine Verschweißung der Anschlussstiftenden an hierfür vorgesehenen metallischen Schweißlaschen der Kontaktbaugruppe 42. Vor oder nach dieser Verschweißung erfolgt eine finale Ummantelung des oberen Endes des Stellantriebs 38. Diese Ummantelung ist im dargestellten Beispiel von einer finalen Kunststoffumspritzung 52 gebildet und besitzt den Vorteil, dass die Rastverbindung zwischen dem Aktorgehäuse 46 und der Kontaktbaugruppe 42 gesichert wird.

Bei der nachfolgenden Beschreibung von weiteren Ausführungsbeispielen werden für analoge Komponenten die gleichen Bezugszahlen verwendet, jeweils ergänzt durch einen kleinen Buchstaben zur Unterscheidung der Ausführungsform. Dabei wird im Wesentlichen nur auf die Unterschiede zu dem bzw. den bereits beschriebenen Ausführungsbeispielen eingegangen und im Übrigen hiermit ausdrücklich auf die Beschreibung vorangegangener Ausführungsbeispiele verwiesen.

Fig. 2 zeigt eine Abdichteinheit 18a, bei welcher im Unterschied zu der mit Bezug auf Fig. 1 beschriebenen Ausführungsform ein Träger 22a sich in Radialrichtung weniger weit nach außen erstreckt. Der wieder als Einlegeteil in einem Umspritzungsprozess verwendete Träger 22a befindet sich hierbei nur im Zentrum der fertigen Dichtung 26a. Diese Gestaltung trägt insbesondere dem Umstand Rechnung, dass die stabilisierende Wirkung des Trägers 22a vor allem im Bereich einer Membran 20a aus mikroporösem Material bedeutsam ist. Der dargestellte Deckel 30 ist optional.

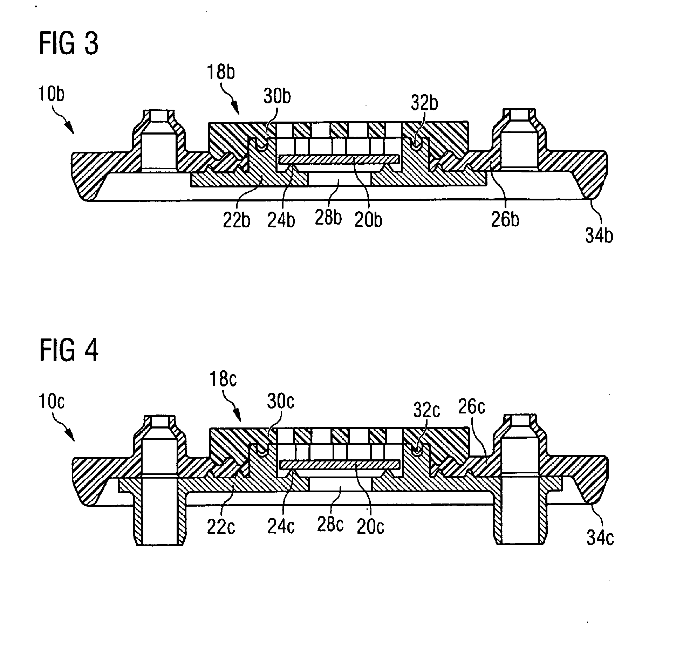

Fig. 3 zeigt eine Abdichteinheit 18b, bei welcher die Verbindung zwischen dem Elastomermaterial einer Dichtung 26b und einem Träger 22b ausschließlich durch eine axiale Verpressung erreicht wird. Die Bauteile Träger 22b, Membran 20b, Dichtung 26b und Träger- bzw. Schutzdeckel 30b wurden in getrennten Arbeitsschritten hergestellt und anschließend zusammengefügt. Die Verbindung zwischen dem Träger 22b und dem Schutzdeckel 30b ist wieder als unlösbare Schweißverbindung (z. B. Ultraschallschweißung (bei 32b)) realisiert. Verglichen mit der Ausführungsform nach Fig. 1 besitzt der Schutzdeckel 30b radial außerhalb der Verschweißung 32b einen radial weiter nach außen ausladenden und das Material der Dichtung 26b gegen den Träger 22b drückenden Umfangsrand. Das Elastomer wird hierbei am Deckelrand umlaufend verpresst, was eine gute Dichtwirkung an der Grenzfläche zwischen dem Träger 22b und dem Dichtmaterial 26b bewirkt. Auch hier könnte der Schutzdeckel 30b als einfacher Pressring ausgeführt werden, sofern eine Membranbeschädigung im konkreten Anwendungsfall nicht zu befürchten ist.

Fig. 4 zeigt eine Abdichteinheit 18c, bei welcher im Unterschied zu der Ausführungsform nach Fig. 3 ein Träger 22c sich radial weiter nach außen bis über die Radialpositionen der Anschlussstifte hinaus erstreckt und im Bereich der Anschlussstifte Öffnungen zum Durchtritt derselben aufweist.

Ein besonderer Vorteil dieser Ausführungsform besteht, wie dargestellt, darin, dass der Träger 22c mit axial nach unten abstehenden Hülsenfortsätzen ausgebildet sein kann, die im montierten Zustand in die Durchtrittsöffnungen (Bohrungen) der Kopfanordnung hineinragen, um dort die Anschlussstifte gegenüber den Innenwandungen der Durchtrittsöffnungen elektrisch zu isolieren und/oder zu zentrieren.

Die Gestaltung des vergleichsweise großflächigen Trägers 22b mit den Hülsenfortsätzen kombiniert gewissermaßen den Träger und die bei den vorangehend beschriebenen Ausführungsformen optional vorzusehende Isolierscheibe miteinander.

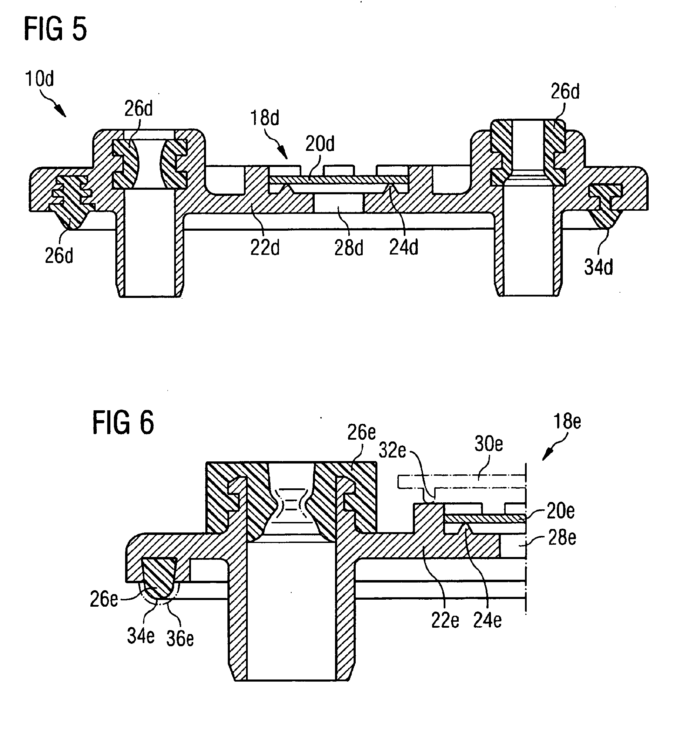

Fig. 5 zeigt eine Abdichteinheit 18d, bei welcher ein Träger 22d ein Hauptbauteil darstellt, an dem einerseits wieder eine mikroporöse Membran 20d festgelegt ist und andererseits im Wesentlichen nur an den "Dichtungsstellen" ein dichtendes Material 26d vorgesehen ist. Zur Veranschaulichung verschiedener Gestaltungsvarianten der Radialabdichtung sind in Fig. 5 links und rechts verschiedene solche Gestaltungen gezeichnet.

Im Unterschied zu den oben beschriebenen Ausführungsformen bilden die einzelnen Dichtmaterialabschnitte also keinen zusammenhängenden Bereich sondern einen ringförmig zusammenhängenden Bereich zur Axialabdichtung und zwei davon separate Materialbereiche zur Radialabdichtung der Anschlussstifte. Die Dichtung 26d ist also dreiteilig ausgeführt und - wie dargestellt - durch Formschluss am Träger 22d gehalten.

Das Dichtmaterial 26d wurde hierbei durch ein ZweiKomponenten-Spritzgussverfahren in einem Fertigungsschritt zusammen mit dem Träger 22d hergestellt, der wie bei der Ausführungsform nach Fig. 4 mit nach unten vorstehenden Hülsenabschnitten ausgebildet ist.

Für eine innige Verbindung zwischen den Materialabschnitten der Dichtung 26d und dem Träger 22d könnte unabhängig von einer mechanischen Druckbeaufschlagung auch z. B. eine Vulkanisation vorgesehen sein.

Eine weitere Möglichkeit zur Gestaltung des Formschlusses zwischen der Dichtung und dem Träger ist in Fig. 6 veranschaulicht.

Fig. 6 zeigt einen dem linken Bereich von Fig. 5 entsprechenden Abschnitt einer Abdichteinheit 18e, bei welcher im Unterschied zu der Ausführungsform nach Fig. 5 das zur Radialabdichtung an einem Träger 22e angeordnete Dichtmaterial 26e das obere Ende eines axial nach oben hin abstehenden Hülsenfortsatzes umgreift.

Im Bereich der Radialabdichtung ist ein radialer Dichtwulst am Innenumfang des entsprechenden Materialabschnitts der Dichtung 26e vorgesehen, welcher - nach Aufsetzen der Abdichteinheit auf die Anschlussstifte - die Dichtwirkung durch radiale Verpressung vergrößert.

Bei der Axialabdichtung ist die formschlüssige Verbindung zwischen dem Träger 22e und dem entsprechenden Dichtmaterialabschnitt durch einen geringfügigen Hinterschnitt realisiert, wie dargestellt.

Insbesondere bei dieser Variante wäre als Alternative zu einer Umspritzung auch eine nachträgliche Montage vorgefertigter Einzeldichtungen 26e zur Radialabdichtung denkbar.

Fig. 7 zeigt eine der Fig. 6 entsprechende Ansicht einer Abdichteinheit 18f, bei welcher ein im Wesentlichen scheibenförmiger Träger 22f an seinem Außenumfang von Dichtmaterial 26 umgriffen wird. Die Dichtung 26f ist hierbei insgesamt ringförmig ausgebildet.

Eine weitere Besonderheit der Ausführungsform nach Fig. 7 besteht darin, dass eine innige Verbindung der angrenzenden Werkstoffe (Träger 22f, Dichtung 26f) durch eine "Aktivierung der Oberflächen" erreicht wurde, hier durch eine Vulkanisation der aneinander angrenzenden Werkstoffoberflächen. Durch diese Maßnahme ist dann keine nachträgliche Anpressung bzw. Verpressung von Material der Dichtung 26f gegen den Träger 22f (z. B. durch den (optionalen) Deckel) notwendig.

Sämtliche bis hierher beschriebenen Abdichteinheiten sind für eine Installationsumgebung der in Fig. 8 gezeigten und oben bereits erläuterten Art geeignet.

Soweit bei diesen Ausführungsformen die Geometrie an der Unterseite der Abdichteinheit zur Zwischenfügung eines Isolierteils zwischen der Abdichteinheit und der Kopfanordnung ausgebildet ist, so kann ein solches Isolierteil beispielsweise als eine Isolierscheibe 54h vorgesehen sein, wie sie in Fig. 10 dargestellt ist.

Die in Fig. 10 gezeigte Isolierscheibe 54h besteht aus einem Scheibenkorpus 56h, an welchem sich nach unten hin Hülsenfortsätze 58h anschließen, durch welche im montierten Zustand die Anschlussstifte des Piezoaktors hindurchtreten und welche diese Anschlussstifte gegen die Kopfplatte isolieren. Um hierbei den Gasaustausch zwischen dem Aktorraum und der Außenseite der Abdichteinheit möglichst wenig zu beeinträchtigen, sind Belüftungsöffnungen 60h vorgesehen, die einen Gasaustausch zwischen den axial einander entgegengesetzten Seiten der Isolierscheibe 54h fördern.

Prinzipiell könnten derartige Belüftungsöffnungen 60h an beliebiger Stelle der Isolierscheibe 56h angeordnet sein. Für ein möglichst großes Gasaustauschvermögen zwischen den axial einander entgegengesetzten Stirnseiten der Isolierscheibe 54h sind Belüftungsöffnungen 60h - wie dargestellt - bevorzugt etwa im Bereich der Hülsenfortsätze 58h anzuordnen. Insbesondere im Bereich der Umfangsfläche der Hülsenfortsätze 58h ist durch den dort befindlichen Ringspalt ein Gasaustauschweg in den Aktorraum hinein gegeben. Um den Gasdurchsatz entlang dieser Umfangsflächen weiter zu verbessern, sind bei der dargestellten Isolierscheibe 54h axial verlaufende Belüftungsnuten 62h vorgesehen, die jeweils in eine der Belüftungsöffnungen 60h münden.

Abweichend vom dargestellten Beispiel nach Fig. 10 können die Belüftungsöffnungen 60h auch eine oder mehrere, durchaus sehr großflächige Öffnungen im Zentrum der Isolierscheibe 54h umfassen. Auch ist es zur Vergrößerung des effektiven Aktorraumvolumens von Vorteil, wenn die Isolierscheibe 54h an einer oder beiden Stirnseiten mit großflächigen Aussparungen (z. B. im Zentrum) ausgebildet ist.

Fig. 9 veranschaulicht eine beispielhafte Installationsumgebung der mit Bezug auf Fig. 6 bereits erläuterten Abdichtungsannordnung 10e in einem Kraftstoffinjektor. Dargestellt ist lediglich der Bereich um einen von zwei Anschlussstiften 12e. Die Abdichteinheit 18e wird im installierten Zustand entlang eines ringförmig geschlossenen Umfangsbereichs durch einen Vorsprung 64e einer Kontaktbaugruppe 42e axial belastet, um die zuverlässige Axialabdichtung (Eingriff des Dichtmaterialvorsprungs 34e in die Aktorgehäusenut 36e) zu gewährleisten. Bei der Montage des Kraftstoffinjektors wird nach dieser Verpressung und Herstellung der elektrischen Weiterverbindung durch die Kontaktbaugruppe 42e eine finale Kunststoffumspritzung 52e zur Sicherung der Befestigung der Kontaktbaugruppe 42e vorgenommen und schließlich ein Gehäusedeckel 66e aus Kunststoff am oberen Ende der Konstruktion durch eine Ultraschallverschweißung befestigt.

Wenn der einstückig mit dem Träger 22e ausgebildete, nach unten in die Bohrung 16e abstehende Hülsenfortsatz mit einem rechteckigen, z. B. quadratischen Außenprofil gestaltet ist, so ergeben sich vorteilhaft vergleichsweise große Belüftungsspalte zwischen dem Hülsenfortsatz und der Innenwandung der Bohrung 16e. Zur weiteren Steigerung der Gasdurchlässigkeit ist es zweckmäßig, wenn - wie dargestellt - die Kontaktbaugruppe 42e (z. B. unter anderem unmittelbar über dem mikroporösen Teil 20e) eine oder mehrere weitere Belüftungsöffnungen 63e aufweist.

Bei den oben beschriebenen Ausführungsformen wird die Dichtung zwischen der mikroporösen Membran und deren Träger durch eine Verschweißung erzielt. Abweichend von diesem Beispiel könnte diese Dichtung auch in anderer Weise bewerkstelligt werden.

Bei allen Ausführungsbeispielen führt die Integration einer Membran aus mikroporösem Material zu einer Steigerung der Gaspermeationsfähigkeit, ohne den Schutz vor einen Eindringen von flüssigen Medien in den Aktorraum zu beeinträchtigen. Da die Gasaustauschfähigkeit durch ein mikroporöses Teil unabhängig von dem Dichtmaterial realisiert wird, lassen sich die beiden Werkstoffe unabhängig voneinander und somit funktionsoptimal auswählen. Die Montage eines Kraftstoffinjektors wird erheblich vereinfacht durch Bereitstellung einer kompletten Abdichteinheit, die als eine Montagekomponente verbaut werden kann. Die Abdichteinheit ermöglicht eine gute Belüftung des Piezoaktors und somit eine Steigerung der Dauerhaltbarkeit der hierfür verwendeten Piezokeramik.

## Patentansprüche

1. Abdichtungsanordnung zur Abdichtung eines Piezoaktors (40) eines Kraftstoffinjektors einer Brennkraftmaschine mit aus dem Piezoaktor hervorstehenden Anschlussstiften (12) und einer auf den Piezoaktor aufgesetzten Kopfanordnung (14), die mit Öffnungen (16) zum Durchtritt der Anschlussstifte versehen ist, **gekennzeichnet durch** eine auf die Kopfanordnung (14) aufgesetzte und mit Öffnungen zum Durchtritt der Anschlussstifte (12) versehene Abdichteinheit (18), die einen Träger (22) aufweist, an welchem ein dichtendes Material (26) angeordnet ist, das an Umfangsflächen der Anschlussstifte (12) und an einem Umfangsbereich der Kopfanordnung (14) dichtend anliegt, und an welchem ein aus mikroporösem Material gebildetes Teil (20) zur Schaffung einer Gaspermeabilität integriert ist.

2. Abdichtungsanordnung nach Anspruch 1, wobei der Träger (22) aus Kunststoff gebildet ist.

3. Abdichtungsanordnung nach einem der vorangehenden Ansprüche, wobei das dichtende Material (26) ein Elastomer ist.

4. Abdichtungsanordnung nach einem der vorangehenden Ansprüche, wobei das dichtende Material (26) als eine Umspritzung des Trägers (22) ausgebildet ist.

5. Abdichtungsanordnung nach einem der vorangehenden Ansprüche, wobei das dichtende Material (26) als eine Komponente in einem 2-Komponenten-Spritzgussverfahren hergestellt ist.

6. Abdichtungsanordnung nach einem der vorangehenden Ansprüche, wobei zwischen dem Material des Trägers (22) und dem dichtenden Material (26) eine innige Verbindung durch eine Vulkanisation geschaffen ist.

7. Abdichtungsanordnung nach einem der vorangehenden Ansprüche, wobei das dichtende Material (26) zum Träger (22) hin verpresst ist.

8. Abdichtungsanordnung nach einem der vorangehenden Ansprüche, wobei das aus dem mikroporösen Material gebildete Teil (20) mit dem Träger (22) verschweißt ist.

9. Abdichtungsanordnung nach einem der vorangehenden Ansprüche, wobei das mikroporöse Material (20) von expandiertem Polytetrafluorethylen ePTFE, gebildet ist.

10. Abdichtungsanordnung nach einem der vorangehenden Ansprüche, wobei das aus dem mikroporösen Material gebildete Teil (20) im Wesentlichen scheibenförmig ist.

## Claims

1. Sealing arrangement for sealing a piezo-actuator (40) of a fuel injector in an internal combustion engine with terminal posts (12) projecting out of the piezo-actuator and a head arrangement (14) mounted on the piezo-actuator, provided with openings (16) for passage of the terminal posts, **characterised by** a sealing unit (18) mounted on the head arrangement (14) and provided with openings for passage of the terminal posts (12), which has a support (22), on which a sealing material (26) is arranged, which is in contact in a sealing manner with the peripheral surfaces of the terminal posts (12) and with a peripheral region of the head arrangement (14) and in which an element (20) made of a microporous material is integrated to create gas permeability.

2. Sealing arrangement according to claim 1, whereby the support (22) is made of plastic.

3. Sealing arrangement according to one of the preceding claims, whereby the sealing material (26) is an elastomer.

4. Sealing arrangement according to one of the preceding claims, whereby the sealing material (26) is configured as a moulding around the support (22).

5. Sealing arrangement according to one of the preceding claims, whereby the sealing material (26) is produced as a component in a twin-component injection moulding method.

6. Sealing arrangement according to one of the preceding claims, whereby a close connection is created by vulcanization between the material of the support (22) and the sealing material (26).

7. Sealing arrangement according to one of the preceding claims, whereby the sealing material (26) is compressed towards the support (22).

8. Sealing arrangement according to one of the preceding claims, whereby the element (20) made from the microporous material is welded to the support (22).

9. Sealing arrangement according to one of the preceding claims, whereby the microporous material (20) is made of expanded polytetrafluoroethylene ePTFE.

10. Sealing arrangement according to one of the preceding claims, whereby the element (20) made of microporous material is essentially disk-shaped.

## Revendications

1. Système d'étanchéité pour étanchéifier un actionneur piézo-électrique (40) d'un injecteur de carburant d'un moteur à combustion interne, comprenant des tiges de connexion (12) saillant de l'actionneur piézo-électrique et un dispositif de tête (14) posé sur l'actionneur piézo-électrique, ce dispositif comprenant des ouvertures (16) pour le passage des tiges de connexion, **caractérisé par** une unité d'étanchéité (18) posée sur le dispositif de tête (14) et comportant des ouvertures pour le passage des tiges de connexion (12), cette unité comprenant un support (22) sur lequel une matière d'étanchéification (26) est disposée qui épouse de façon étanche des surfaces périphériques des tiges de connexion (12) et une partie périphérique du dispositif de tête (14), ce support comprenant une pièce en matière microporeuse (20) intégrée pour obtenir une perméabilité gazeuse.

2. Système d'étanchéité selon la revendication 1, dans lequel le support (22) est réalisé en matière synthétique.

3. Système d'étanchéité selon l'une des revendications précédentes, dans lequel la matière d'étanchéification (26) est un élastomère.

4. Système d'étanchéité selon l'une des revendications précédentes, dans lequel la matière d'étanchéification (26) est réalisée sous forme de surmoulage par injection du support (22).

5. Système d'étanchéité selon l'une des revendications précédentes, dans lequel la matière d'étanchéification (26) est fabriquée en tant qu'un des composants dans un procédé de moulage par injection à deux composants.

6. Système d'étanchéité selon l'une des revendications précédentes, dans lequel une connexion intime est réalisée entre la matière du support (22) et la matière d'étanchéification (26) au moyen d'une vulcanisation.

7. Système d'étanchéité selon l'une des revendications précédentes, dans lequel la matière d'étanchéification (26) est comprimée en direction du support (22).

8. Système d'étanchéité selon l'une des revendications précédentes, dans lequel la pièce (20) formée à partir de la matière microporeuse est soudée au support (22).

9. Système d'étanchéité selon l'une des revendications précédentes, dans lequel la matière microporeuse (20) est formée d'un polytétrafluoroéthylène expansé ePTFE.

10. Système d'étanchéité selon l'une des revendications précédentes, dans lequel la pièce réalisée à partir de la matière microporeuse (20) est essentiellement en forme de disque.
